# FASCICULE DE BREVET EUROPEEN

(11) **EP 0 651 502 B1**
(45) Date de publication et mention de la délivrance du brevet: **24.11.1999**
(21) Numéro de dépôt: 94402432.2
(22) Date de dépôt: 27.10.1994
(51) Int. Cl.: H03F 3/45

(54) **Elément d'amplification à structure différentielle en mode de courant**
Verstärkerelement mit Differenzstruktur in Strombetriebsart
Amplifier element with current mode diffential structure

(30) Priorité: 02.11.1993 FR 9313000
(43) Date de publication de la demande: 03.05.1995
(73) Titulaire: ALCATEL, 75008 Paris (FR)
(72) Inventeur: Genest, Pierre, F-95430 Butry Sur Oise (FR)
(74) Mandataire: El Manouni, Josiane

(56) Documents cités:
- EP-A- 0 534 007
- GB-A- 2 010 038
- US-A- 3 867 685
- US-A- 4 757 273
- US-A- 5 132 640
- 1988 IEEE INTERNATIONAL SYMPOSIUM ON CIRCUITS AND SYSTEMS PROCEEDINGS, vol.2, 7 Juin 1988, FINLAND pages 1923 - 1926, XP92213 E. SEEVINCK 'DESIGN AND APPLICATION OF INTEGRATED ANALOG INTERFACE CIRCUITS'

## Description

Le domaine de l'invention est celui du traitement analogique d'un signal. Un tel traitement, qui consiste notamment à amplifier un signal, par exemple avant sa conversion en numérique, ne peut être effectué que sur un signal possédant une énergie suffisante car ce traitement consomme généralement beaucoup d'énergie. Or, d'une façon générale, un signal à traiter est un signal à faible énergie et il convient donc d'amplifier préalablement l'énergie de ce signal avant son traitement.

L'invention concerne un élément d'amplification permettant une telle amplification de l'énergie d'un signal afin que son traitement soit possible.

L'invention peut par exemple être mise en oeuvre dans un circuit électronique entièrement différentiel. Dans ce cas, des éléments d'amplification selon l'invention peuvent être placés en alternance avec des étages de filtrage.

Plus généralement, l'invention peut s'appliquer dans tous les cas où un élément doit fournir un gain (souvent assez faible).

On connaît, dans l'état de la technique, plusieurs types d'éléments d'amplification.

Certains éléments d'amplification connus sont basé sur l'utilisation d'une structure non différentielle. Cette structure non différentielle présente plusieurs inconvénients, à savoir notamment un bruit et un offset importants.

D'autre éléments d'amplification connus sont basé sur l'utilisation d'une structure différentielle. Cette structure différentielle n'induit ni bruit, ni offset importants, mais présente néanmoins des inconvénients.

En effet, si cette structure différentielle est réalisée en mode de tension, la valeur du gain est difficile à contrôler, la consommation énergétique ne peut être faible qu'au détriment de la rapidité, et l'obtention d'une large bande passante nécessite une importante consommation de courant.

On pourra se référer au document US 5 132 640 pour un élément d'amplification en mode de courant.

Par ailleurs, si cette structure différentielle est réalisée en mode de courant, elle pallie les inconvénients liés à une structure non différentielle mais il existe alors un gain de mode commun indésirable.

Enfin , les éléments d'amplification basés sur cette structure différentielle, que celle-ci soit réalisée en mode de tension ou en mode de courant, sont généralement des amplificateurs opérationnels, c'est-à-dire des éléments destinés à être systématiquement rebouclés.

Ainsi, même pour obtenir un gain faible, ces amplificateurs opérationnels sont utilisés rebouclés. Il est par exemple fréquent d'utiliser un amplificateur opérationnel présentant un gain élevé (égal à 1 000 par exemple) en boucle ouverte pour obtenir un gain faible (égal à 10 par exemple) en boucle fermée. Il est clair qu'il existe alors une surconsommation de courant.

L'invention a notamment pour objectif de pallier ces différents inconvénients de l'état de la technique.

Plus précisément, un objectif de l'invention est de fournir un élément d'amplification présentant une faible consommation tout en possédant une large bande passante.

Un objectif complémentaire de l'invention est de fournir un tel élément d'amplification pouvant être utilisé en boucle ouverte.

Un autre objectif de l'invention est de fournir un tel élément d'amplification présentant un bruit réduit, un faible offset de courant, une bonne précision pour la définition du gain, et une bonne réjection de mode commun.

L'invention a également pour objectif de fournir un tel élément d'amplification qui puisse être réalisé aussi bien avec des transistors bipolaires qu'avec des transistors MOS.

Ces objectifs, ainsi que d'autres qui apparaîtront par la suite, sont atteints selon l'invention à l'aide d'un élément d'amplification à structure différentielle en mode de courant, cet élément d'amplification comprenant :
- des moyens de génération d'un courant en mode commun de polarisation ;
- un multiplieur translinéaire recevant, sur deux entrées, ledit courant de mode commun de polarisation et un courant de mode différentiel à amplifier, et délivrant, sur deux sorties, un courant de mode différentiel amplifié ;
- des moyens de polarisation dudit multiplieur translinéaire à partir dudit courant de polarisation reçu par ledit multiplieur translinéaire ; et
- des moyens de compensation du courant de mode commun sur lesdites sorties du multiplieur translinéaire.

L'élément d'amplification selon l'invention possède donc une structure différentielle en mode de courant. Il peut notamment être utilisé en boucle ouverte directement.

Dans ce cas, l'élément d'amplification selon l'invention n'est pas utilisé rebouclé et son gain en boucle ouverte peut être faible (égal à 10 par exemple) puisqu'il s'agit de son gain d'utilisation réelle. De cette façon, la consommation de courant est limitée.

De plus, l'élément d'amplification selon l'invention possède les avantages liés à la structure différentielle, à savoir un faible bruit et un faible offset, ainsi que ceux liés au mode de courant, à savoir une large bande passante et une bonne précision pour la définition du gain.

L'amplification proprement dite est réalisée de façon originale grâce à un multiplieur translinéaire. Il est à noter en effet que les multiplieurs translinéaires sont généralement utilisés pour reproduire des fonctions mathématiques complexes (telles que les racines carrées, les valeurs absolues, etc...) ou encore pour réaliser des mélangeurs.

Enfin, les moyens de polarisation du multiplieur translinéaire et les moyens de compensation du courant de mode commun en sortie du multiplieur translinéaire permettent une utilisation effective en boucle ouverte de l'élément d'amplification de l'invention.

En effet, seul le courant de mode différentiel représente un signal utile et doit être amplifié. Or, il se peut que le multiplieur translinéaire reçoive sur ses entrées une composante de mode commun supplémentaire, distincte de celle permettant la polarisation.

Dans ce cas, le rapport entre le courant présent sur une sortie et le courant présent sur l'entrée correspondante n'est plus égal au gain prédéterminé. On parle alors de mauvaise précision du gain.

De plus, cette composante de mode commun supplémentaire se retrouve sur les sorties du multiplieur translinéaire. On parle alors de mauvaise réjection du mode commun.

Précisément, le rôle des moyens de polarisation du multiplieur translinéaire est d'obtenir une bonne précision sur le gain, et le rôle des moyens de compensation du courant de mode commun est d'obtenir une très bonne réjection de mode commun.

Avantageusement, ledit multiplieur translinéaire comprend une paire de transistors d'entrée et au moins une paire différentielle de transistors de sortie, lesdits transistors de sortie de la paire différentielle présentant une première borne commune constituant un point d'addition des courants amplifiés traversant lesdits transistors de sortie du multiplieur translinéaire,
lesdits moyens de polarisation comprenant au moins un miroir de courant constitué d'une première branche véhiculant un courant d'origine et au moins une seconde branche véhiculant un courant copié, ladite première branche de miroir de courant comprenant un transistor de première branche relié par une première borne auxdits transistors d'entrée du multiplieur translinéaire, ladite seconde branche de miroir de courant comprenant un transistor de seconde branche relié par une première borne audit point d'addition de courant dudit multiplieur translinéaire et par une seconde borne à une seconde borne dudit transistor de première branche,
et lesdits moyens de compensation du courant de mode commun comprenant :
   - des moyens de recopie du courant de mode commun véhiculé par ledit transistor de seconde branche de miroir de courant, et
   - des moyens d'injection d'un courant de mode commun recopié par lesdits moyens de recopie de courant dans une seconde borne de chacun desdits transistors de sortie du multiplieur translinéaire, lesdites secondes bornes desdits transistors de sortie constituant lesdites sorties du multiplieur translinéaire.

Ainsi, grâce aux miroirs de courant, la polarisation du multiplieur translinéaire est automatique.

Par ailleurs, les moyens de polarisation assurent que le courant de mode commun traversant un transistor de sortie du multiplieur translinéaire est égal au produit du gain par le courant de mode commun traversant le transistor de l'entrée correspondante. Ainsi, l'élément rayonnant présente une bonne précision sur le gain.

Enfin, les moyens de compensation du courant de mode commun assurent que le courant de mode commun injecté dans un transistor de sortie du multiplieur translinéaire est identique au courant de mode commun le traversant. Ainsi, l'élément rayonnant présente une très bonne réjection du mode commun.

De façon avantageuse, lesdits moyens de recopie du courant de mode commun comprennent une seconde branche de miroir de courant supplémentaire comprenant un transistor de seconde branche relié par une première borne auxdits moyens d'injection et par une seconde borne à ladite seconde borne du transistor de première branche desdits moyens de polarisation.

Préférentiellement, lesdits moyens de recopie du courant de mode commun comprennent des moyens de maintien d'une tension constante permettant d'obtenir sur ladite première borne dudit transistor de la seconde branche de miroir de courant supplémentaire une tension égale à celle existant sur ladite première borne dudit transistor de première branche des moyens de polarisation.

Ainsi, on supprime les éventuelles fluctuations de tension dues au courant différentiel et on s'assure que la seconde branche supplémentaire de miroir de courant réalise une copie correcte de courant.

De façon préférentielle, lesdits moyens de maintien d'une tension constante comprennent :
- un premier transistor de maintien de tension relié par une première borne auxdits moyens d'injection d'un courant recopié, par une seconde borne à une desdites entrées du multiplieur translinéaire, et par une troisième borne à ladite première borne du transistor de seconde branche de miroir de courant supplémentaire, et
- un second transistor de maintien de tension relié par une première borne auxdits moyens d'injection d'un courant recopié, par une second borne à l'autre desdites entrées du multiplieur translinéaire, et par une troisième borne à ladite première borne du transistor de seconde branche de miroir de courant supplémentaire.

Avantageusement, lesdits moyens d'injection d'un courant recopié comprennent au moins deux premiers miroirs de courant possédant chacun une première branche reliée auxdits moyens de recopie de courant en mode commun, et une seconde branche reliée à l'une desdites sorties du multiplieur translinéaire, lesdites premières branches des deux premiers miroirs de courant étant communes.

Préférentiellement, lesdits moyens d'injection d'un courant recopié comprennent deux seconds miroirs de courant cascadés auxdits premiers miroirs de courant.

Ces seconds miroirs de courant permettent d'améliorer la résistance de sortie des transistors des premiers miroirs de courant.

Avantageusement, lesdits moyens de génération d'un courant de mode commun de polarisation appartiennent au groupe comprenant les sources de courant et les résistances.

Dans un mode de réalisation préférentiel de l'invention, l'élément d'amplification comprend une cellule d'entrée, placée en amont dudit multiplieur translinéaire et possédant une très faible impédance d'entrée.

Avantageusement, ladite cellule d'entrée comprend un double convoyeur de courant.

De façon avantageuse, l'élément d'amplification comprend des transistors appartenant au groupe comprenant les transistors bipolaires et les transistors MOS.

Dans un premier mode de réalisation avantageux de l'invention, les transistors compris dans ledit multiplieur translinéaire, lesdits moyens de polarisation et lesdits moyens de recopie de courant de mode commun sont du type NPN,
et les transistors compris dans lesdits moyens d'injection d'un courant recopié sont du type PNP.

Dans un second mode de réalisation avantageux de l'invention, les transistors compris dans ledit multiplieur translinéaire, lesdits moyens de polarisation et lesdits moyens de recopie de courant de mode commun sont du type PNP,
et les transistors compris dans lesdits moyens d'injection d'un courant recopié sont du type NPN.

Dans un troisième mode de réalisation avantageux de l'invention, les transistors compris dans ledit multiplieur translinéaire, lesdits moyens de polarisation et lesdits moyens de recopie de courant de mode commun sont du type PMOS,
et les transistors compris dans lesdits moyens d'injection d'un courant recopié sont du type NMOS.

Dans un quatrième mode de réalisation avantageux de l'invention, les transistors compris dans ledit multiplieur translinéaire, lesdits moyens de polarisation et lesdits moyens de recopie de courant de mode commun sont du type NMOS,
et les transistors compris dans lesdits moyens d'injection d'un courant recopié sont du type PMOS.

En d'autres termes, dans ces différents modes de réalisation, l'élément d'amplification comprend deux ensembles de moyens
(à savoir un premier ensemble de moyens comprenant le multiplieur translinéaire, les moyens de polarisation et les moyens de recopie de courant, et un second ensemble de moyens comprenant les moyens d'injection de courant), chaque ensemble de moyens utilisant des transistors possédant une structure distincte et symétrique par rapport à celle des transistors de l'autre ensemble de moyens.

Ainsi, lorsqu'un ensemble de moyens comprend des transistors NMOS (respectivement PNP), l'autre ensemble de moyens comprend des transistors PMOS (respectivement NPN).

D'autres caractéristiques et avantages de l'invention apparaîtront à la lecture de la description suivante de deux modes de réalisation préférentiels de l'invention, donnés à titre d'exemple indicatif et non limitatif, et des dessins annexés dans lesquels :
- la figure 1 présente un schéma de principe d'un exemple d'élément d'amplification selon l'invention ;
- la figure 2 présente un schéma logique simplifié d'un élément d'amplification selon l'invention ;
- la figure 3 présente un schéma électrique simplifié d'un premier mode de réalisation d'un élément d'amplification selon l'invention ; et
- la figure 4 présente un schéma électrique simplifié d'un second mode de réalisation d'un élément d'amplification selon l'invention.

L'invention concerne donc un élément d'amplification à structure différentielle en mode de courant. Cet élément d'amplification peut par exemple être utilisé en boucle ouverte, comme c'est le cas dans la suite de la description. Il est clair toutefois que l'invention n'est pas limitée à ce seul mode d'utilisation et peut également, dans certains cas, être utilisée rebouclée (directement ou indirectement).

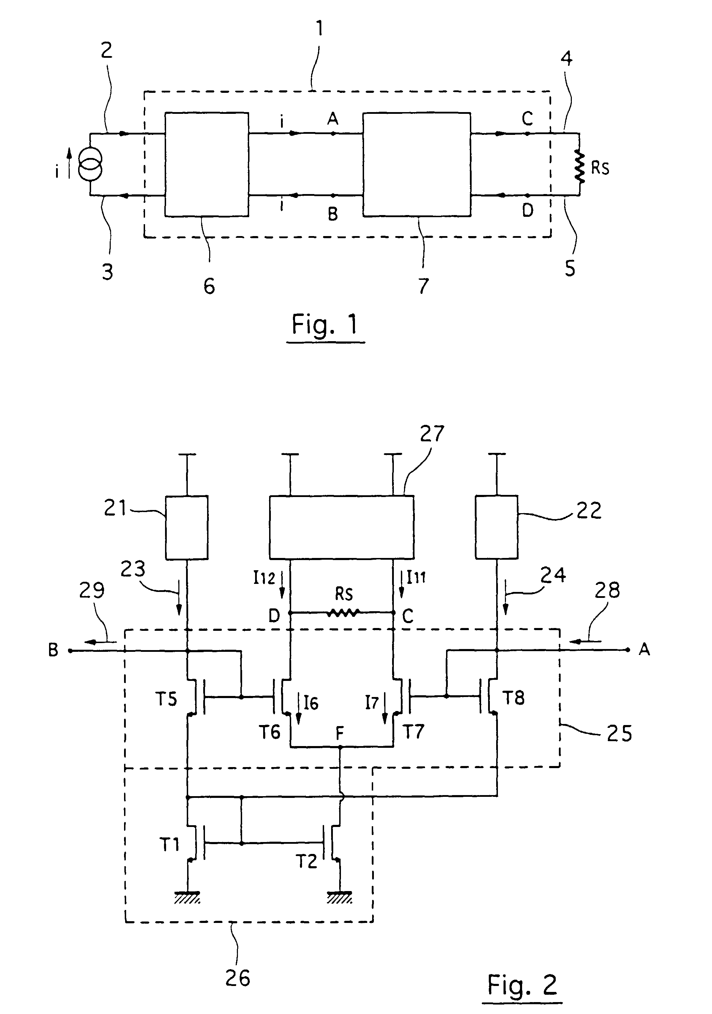

Comme présenté sur le schéma de principe de la figure 1, un tel élément d'amplification 1 possède deux entrées différentielles 2, 3 de courant à amplifier et deux sorties différentielles 4, 5 de courant amplifié. Ces deux sorties différentielles 4, 5 sont reliées à une charge ou à un autre élément (de filtrage ou encore d'amplification, par exemple). Ces différents cas sont symbolisés par la résistance de sortie R_{S}.

Dans l'exemple présenté sur la figure 1, l'élément d'amplification 1 comprend une cellule d'entrée 6 permettant d'obtenir une impédance d'entrée faible. Cette cellule d'entrée 6 comprend par exemple un double convoyeur de courant.

L'utilisation d'une cellule d'entrée 6 étant facultative, et afin de simplifier la suite de la description, on appellera également élément d'amplification" l'ensemble 7 des moyens placés en aval de ladite cellule d'entrée 6.

L'élément d'amplification 7, dont un schéma logique simplifié est présenté sur la figure 2, comprend :
- des moyens 21, 22 de génération d'un courant de mode commun de polarisation 23, 24 ;
- un multiplieur translinéaire 25 ;
- des moyens 26 de polarisation du multiplieur translinéaire 25 ; et
- des moyens 27 de compensation du courant de mode commun en sortie du multiplieur 25.

Les moyens 21, 22 de génération d'un courant de mode commun de polarisation sont par exemple des sources de courant, ou encore des résistances.

Le multiplieur translinéaire 25 possède deux entrées différentielles A, B et deux sorties différentielles C, D. Sur ces deux entrées A,B, il reçoit le courant de mode commun de polarisation 23, 24 et le courant de mode différentiel à amplifier 28, 29. Sur ces deux sorties différentielles C, D, il délivre un courant de mode différentiel amplifié.

Dans la suite de la description, les transistors mis en oeuvre dans l'élément d'amplification selon l'invention sont du type MOS. Il est clair toutefois que l'invention peut également être mise en oeuvre avec des transistors bipolaires, l'homme du métier ne rencontrant aucun obstacle majeur au passage du type MOS au type bipolaire.

Comme présenté sur la figure 2, le multiplieur translinéaire 25 comprend une paire de transistors d'entrée T5, T8, et une paire différentielle de transistors de sortie T6, T7.

Dans cet exemple, les transistors utilisés dans le multiplieur translinéaire 25 sont du type NMOS et les sources des transistors de sortie de la paire différentielle T6, T7 sont reliées ensemble et constituent un point d'addition F des courant amplifiés I₆, I₇ traversant les transistors de sortie T6, T7.

Les moyens 26 de polarisation comprennent un miroir de courant (T1, T2), permettant une polarisation automatique du multiplieur translinéaire.

Dans l'exemple présenté sur la figure 2, ce miroir de courant (T1, T2) est constitué de :
- une première branche constituée d'un transistor T1 dont le drain est relié aux sources des transistors d'entrée T5, T8 du multiplieur, et
- une seconde branche constituée d'un transistor T2 dont le drain est relié au point d'addition F, et la grille est reliée à la grille du transistor T1 de la première branche.

Les transistors utilisés dans les moyens 26 de polarisation sont du type NMOS.

En résumé, les moyens 26 de polarisation reçoivent, dans la première branche, un courant de mode commun (constitué du courant de polarisation 23, 24 et éventuellement d'une composante supplémentaire (d'erreur)) par l'intermédiaire des transistors d'entrée T5, T8 du multiplieur translinéaire 25, et le recopient (en le multipliant), dans la seconde branche, afin de polariser les transistors de sortie T6, T7 de la paire différentielle du multiplieur translinéaire 25. Ainsi, lorsqu'il existe une composante supplémentaire (d'erreur) de courant de mode commun, celle-ci , n'altère pas la valeur du gain puisqu'elle est également multipliée par les transistors de la paire différentielle du multiplieur.

Les moyens 27 de compensation du courant de mode commun n'ont aucune influence sur le gain différentiel du multiplieur translinéaire 25 mais assurent que les courants de mode commun (constitué du courant de polarisation et d'un éventuel courant supplémentaire) I₁₁, I₁₂ qu'ils délivrent aux transistors de sortie du multiplieur translinéaire sont identiques aux courants de polarisation I₆, I₇ traversant ces transistors de sortie. En d'autres termes, avec les références choisies, les moyens de compensation 27 assurent que : I₁₁ = I₇ et I₁₂ = I₆.

Ainsi, une éventuelle composante de mode commun (pouvant exister du fait que les moyens 26 de polarisation recopient dans ces transistors de sortie tout le courant de mode commun traversant les transistors d'entrée du multiplieur translinéaire) n'est pas reportée dans les sorties C, D de l'élément d'amplification. L'élément d'amplification présente donc une très bonne réjection de mode commun.

Le principe de l'invention consiste donc, afin d'éviter l'amplification du mode commun, à remplacer les sources de courant associées aux transistors de sortie T6, T7 du multiplieur translinéaire 25, par un asservissement sur le courant de polarisation provenant des sources de courant associées aux transistors d'entrée T5, T8 du multiplieur translinéaire 25.

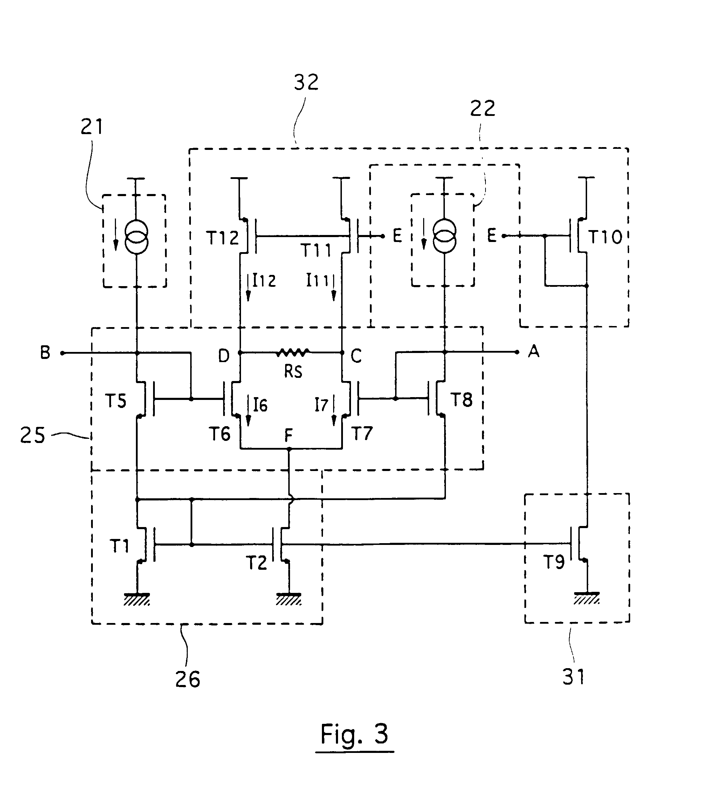

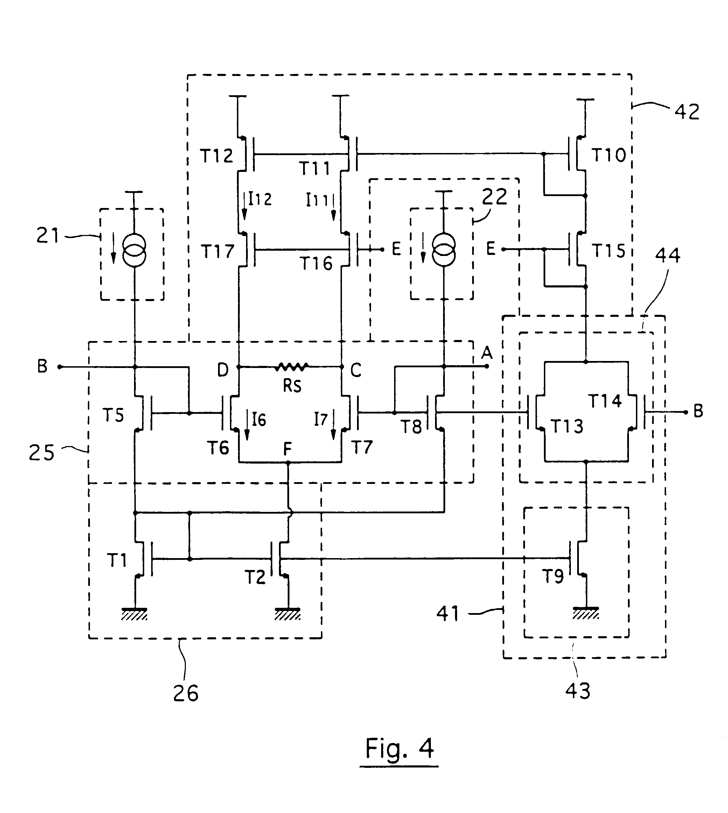

Les figures 3 et 4 présentent chacune un schéma électrique simplifié d'un mode de réalisation distinct d'un élément d'amplification selon l'invention.

On retrouve sur ces deux figures certains modules présentés auparavant en relation avec la figure 2, à savoir le multiplieur translinéaire 25, les moyens 26 de polarisation du multiplieur translinéaire, et les moyens 21, 22 de génération d'un courant de mode commun de polarisation (qui sont ici des sources de courant).

Dans ces deux modes de réalisation, les moyens de compensation du courant de mode commun comprennent :
- des moyens 31, 41 de recopie du courant de mode commun de polarisation traversant le transistor T2 de seconde branche du miroir de courant des moyens 26 de polarisation, et
- des moyens 32, 42 d'injection d'un courant recopié par les moyens 31, 41 de recopie de courant, dans les bornes des transistors de sortie T6, T7 du multiplieur translinéaire 25 (bornes qui constituent les sorties différentielles C, D de l'élément d'amplification).

Dans le premier mode de réalisation de l'invention, présenté sur la figure 3, les moyens 31 de recopie du courant de mode commun comprennent une seconde branche supplémentaire de miroir de courant qui coopère avec la première branche du miroir de courant (T1, T2) des moyens 26 de polarisation, afin de constituer un nouveau miroir de courant.

Cette seconde branche supplémentaire de miroir de courant comprend, dans cet exemple, un transistor T9 de type NMOS dont la grille est reliée aux grilles des transistors T1, T2, du miroir de courant des moyens 26 de polarisation, et le drain est relié aux moyens 32 d'injection de courant.

Ainsi, ce transistor T9 de seconde branche supplémentaire a pour fonction de reproduire le courant de mode commun de polarisation qui traverse les transistors T1 et T2.

Les moyens 32 d'injection du courant recopié sont par exemple constitués de deux miroirs de courant (T10, T11), (T10, T12) possédant une première branche commune.

Dans ce cas, comme présenté sur la figure 3, la première branche commune comprend un transistor T10 dont le drain est connecté au drain du transistor T9 de seconde branche supplémentaire des moyens 31 de recopie de courant. La seconde branche de chacun des deux miroirs de courant de ces moyens 32 d'injection de courant recopié comprend un transistor T11, T12 dont la grille est reliée à la grille du transistor T10 de première branche et le drain est relié à une des deux sorties C, D de l'élément amplificateur (c'est-à-dire au drain de l'un des deux transistors de sortie T6, T7 du multiplieur translinéaire 25).

Ainsi, le même courant de mode commun de polarisation I₁₁, I₁₂ traverse les deux transistors T11, T12 et arrive sur les deux sorties différentielles C, D de l'élément d'amplification. Ces courants I₁₁, I₁₂ sont égaux aux courants de polarisation I₆, I₇ traversant les transistors de sortie T₆, T₇ du multiplieur translinéaire 25. Par conséquent, on garantit une très bonne réjection du mode commun.

Dans ce mode de réalisation, les transistors du multiplieur translinéaire 25, des moyens 26 de polarisation et des moyens 31 de recopie du courant sont du type NMOS, et les transistors des moyens 32 d'injection de courant recopié sont du type PMOS.

Il est clair que dans un autre mode de réalisation "symétrique" par rapport à celui-ci, les transistors du type NMOS sont remplacés par des transistors du type PMOS, et vice-versa.

Dans le cas de la réalisation de l'invention avec des transistors bipolaires, les transistors du multiplieur translinéaire 25, des moyens de polarisation 26 et des moyens 31 de recopie de courant sont du type NPN (respectivement PNP), et les transistors des moyens 32 d'injection de courant recopié sont du type PNP (respectivement NPN).

Le second mode de réalisation de l'invention, présenté sur la figure 4, diffère du premier mode de réalisation uniquement par l'ajout de moyens complémentaires dans les moyens 41 de recopie de courant et les moyens 42 d'injection de courant.

Plus précisément, les moyens 41 de recopie de courant comprennent, en plus de la seconde branche supplémentaire 43 (référencée 31 sur la figure 3) de miroir de courant, des moyens 44 de maintien d'une tension constante sur le drain du transistor T9 de la seconde branche supplémentaire. Ainsi, les fluctuations de tension dues au courant différentiel se trouvent supprimées et la copie de courant est améliorée.

La tension constante maintenue sur le drain du transistor T9 est sensiblement égale à la tension existant sur les drains des transistors d'entrée T5, T8 du multiplieur translinéaire 25.

Les moyens 44 de maintien d'une tension constante comprennent par exemple, comme présenté sur la figure 4, deux transistors T13, T14 dont les drains sont reliés (ensemble) au drain du transistor T 10 de première branche des miroirs de courant des moyens 42 d'injection de courant, dont les sources sont reliées (ensemble) au drain du transistor T9 de seconde branche supplémentaire, et dont les grilles sont reliées à une entrée distincte A, B du multiplieur translinéaire 25.

Ainsi, s'il existe un courant différentiel sur les entrées A, B, celui-ci se trouve annulé et le miroir de courant dont le transistor T9 constitue la seconde branche fonctionne parfaitement.

En ce qui concerne les moyens 42 d'injection du courant recopié, deux second miroirs de courant (T15, T16), (T15, T17) sont cascadés aux deux premiers miroirs de courant (T10, T11), (T10, T12) et permettent notamment d'améliorer la résistance de sortie des transistors T10, T11, T12 des premiers miroirs de courant.

## Revendications

1. Elément d'amplification à structure différentielle en mode de courant, caractérisé en ce qu'il comprend :
- des moyens (21, 22) de génération d'un courant de mode commun de polarisation (23, 24) ;
- un multiplieur translinéaire (25) recevant, sur deux entrées (A, B), ledit courant de mode commun de polarisation (23, 24) et un courant de mode différentiel (28, 29) à amplifier, et délivrant, sur deux sorties (C, D), un courant de mode différentiel amplifié ;
- des moyens (26) de polarisation dudit multiplieur translinéaire (25) à partir dudit courant de polarisation reçu par ledit multiplieur translinéaire ; et
- des moyens (27) de compensation du courant de mode commun sur lesdites sorties (C, D) du multiplieur translinéaire, réalisant un asservissement de ce courant de mode commun sur le courant fourni par lesdits moyens de polarisation.

2. Elément d'amplification selon la revendication 1, caractérisé en ce que ledit multiplieur translinéaire (25) comprend une paire de transistors d'entrée (T5, T8) et au moins une paire différentielle de transistors de sortie (T6, T7), lesdits transistors de sortie (T6, T7) de la paire différentielle présentant une première borne commune constituant un point d'addition (F) des courants amplifiés traversant lesdits transistors de sortie (T6, T7) du multiplieur translinéaire (25),
en ce que lesdits moyens (26) de polarisation comprennent au moins un miroir de courant ((T1, T2)) constitué d'une première branche véhiculant un courant d'origine et au moins une seconde branche véhiculant un courant copié, ladite première branche de miroir de courant comprenant un transistor de première branche (T1) relié par une première borne auxdits transistors d'entrée (T5, T8) du multiplieur translinéaire (25), ladite seconde branche de miroir de courant comprenant un transistor de seconde branche (T2) relié par une première borne audit point d'addition de courant (F) dudit multiplieur translinéaire et par une seconde borne à une seconde borne dudit transistor de première branche (T1),
et en ce que lesdits moyens (27) de compensation du courant de mode commun comprennent :
- des moyens (31 ; 41) de recopie du courant de mode commun véhiculé par ledit transistor (T2) de seconde branche de miroir de courant, et
- des moyens (32 ; 42) d'injection d'un courant de mode commun recopié par lesdits moyens (31 ; 41) de recopie de courant dans une seconde borne de chacun desdits transistors de sortie (T6, T7) du multiplieur translinéaire (25), lesdites secondes bornes desdits transistors de sortie constituant lesdites sorties (C, D) du multiplieur translinéaire.

3. Elément d'amplification selon la revendication 2, caractérisé en ce que lesdits moyens (31 ; 41) de recopie du courant de mode commun comprennent une seconde branche de miroir de courant supplémentaire (31 ; 43) comprenant un transistor de seconde branche (T9) relié par une première borne auxdits moyens (32 ; 42) d'injection et par une seconde borne à ladite seconde borne du transistor (T1) de première branche desdits moyens (26) de polarisation.

4. Elément d'amplification selon la revendication 3, caractérisé en ce que lesdits moyens (41) de recopie du courant de mode commun comprennent des moyens (44) de maintien d'une tension constante permettant d'obtenir sur ladite première borne dudit transistor (T9) de la seconde branche de miroir de courant supplémentaire une tension égale à celle existant sur ladite première borne dudit transistor (T1) de première branche des moyens (26) de polarisation.

5. Elément d'amplification selon le revendication 4, caractérisé en ce que lesdits moyens (44) de maintien d'une tension constante comprennent :
- un premier transistor (T13) de maintien de tension relié par une première borne auxdits moyens (42) d'injection d'un courant recopié, par une seconde borne à une desdites entrées (A) du multiplieur translinéaire (25), et par une troisième borne à ladite première borne du transistor (T9) de second branche de miroir de courant supplémentaire, et
- un second transistor (T14) de maintien de tension relié par une première borne auxdits moyens (42) d'injection d'un courant recopié, par une seconde borne à l'autre desdites entrées (B) du multiplieur translinéaire (25), et par une troisième borne à ladite première borne du transistor (T9) de seconde branche de miroir de courant supplémentaire.

6. Elément d'amplification selon l'une quelconque des revendications 2 à 5, caractérisé en ce que lesdits moyens (41 ; 42) d'injection d'un courant recopié comprennent au moins deux premiers miroirs de courant ((T10, T11), (T10, T12)) possédant chacun une première branche reliée auxdits moyens (31 ; 41) de recopie de courant en mode commun, et une seconde branche reliée à l'une desdites sorties (C, D) du multiplieur translinéaire (25), lesdites premières branches des deux premiers miroirs de courant étant communes.

7. Elément d'amplification selon la revendication 6, caractérisé en ce que lesdits moyens (41) d'injection d'un courant recopié comprennent deux seconds miroirs de courant ((T15 , T16), (T15, T17)) cascadés auxdits premiers miroirs de courant.

8. Elément d'amplification selon l'une quelconque des revendications 1 à 7, caractérisé en ce que lesdits moyens (21, 22) de génération d'un courant de mode commun de polarisation appartiennent au groupe comprenant les sources de courant et les résistances.

9. Elément d'amplification selon l'une quelconque des revendications 1 à 8, caractérisé en ce que il comprend une cellule d'entrée (6), placée en amont dudit multiplieur translinéaire (25) et possédant une très faible impédance d'entrée.

10. Elément d'amplification selon la revendication 9, caractérisé en ce que ladite cellule d'entrée (6) comprend un double convoyeur de courant.

11. Elément d'amplification selon l'une quelconque des revendications 1 à 10, caractérisé en ce qu'il comprend des transistors appartenant au groupe comprenant les transistors bipolaires et les transistors MOS.

12. Elément d'amplification selon la revendication 11 et l'une quelconque des revendications 2 à 10, caractérisé en ce que les transistors compris dans ledit multiplieur translinéaire (25), lesdits moyens (26) de polarisation et lesdits moyens (31 ; 41) de recopie de courant de mode commun sont du type NPN,
et en ce que les transistors compris dans lesdits moyens (32 ; 42) d'injection d'un courant recopié sont du type PNP.

13. Elément d'amplification selon la revendication 11 et l'une quelconque des revendications 2 à 10, caractérisé en ce que les transistors compris dans ledit multiplieur translinéaire (25), lesdits moyens (26) de polarisation et lesdits moyens (31 ; 41) de recopie de courant de mode commun sont du type PNP,
et en ce que les transistors compris dans lesdits moyens (32 ; 42) d'injection d'un courant recopié sont du type NPN.

14. Elément d'amplification selon la revendication 11 et l'une quelconque des revendications 2 à 10, caractérisé en ce que les transistors compris dans ledit multiplieur translinéaire (25), lesdits moyens (26) de polarisation et lesdits moyens (31 ; 41) de recopie de courant de mode commun sont du type NMOS,
et en ce que les transistors compris dans lesdits moyens (32 ; 42) d'injection d'un courant recopié sont du type PMOS.

15. Elément d'amplification selon la revendication 11 et l'une quelconque des revendications 2 à 10, caractérisé en ce que les transistors compris dans ledit multiplieur translinéaire (25), lesdits moyens (26) de polarisation et lesdits moyens (31 ; 41) de recopie de courant de mode commun sont du type PMOS,
et en ce que les transistors compris dans lesdits moyens (32 ; 42) d'injection d'un courant recopié sont du type NMOS.

## Patentansprüche

1. Verstärkerelement mit Differenzstruktur in Strombetriebsart, dadurch gekennzeichnet, dass es umfasst:
- Mittel (21, 22) zum Erzeugen eines Gleichtakt-Polarisierungsstromes (23, 24);
- einen translinearen Vervielfacher (multipleur translinéaire) (25), der auf zwei Eingängen (A, B) den Gleichtakt-Polarisierungsstrom (23, 24) und einen zu verstärkenden Gegentaktstrom (28, 29) empfängt und an zwei Ausgängen (C, D) einen verstärkten Gegentaktstrom ausgibt;
- Mittel (26) zum Polarisieren des translinearen Vervielfachers (25) anhand des von dem translinearen Vervielfacher empfangenen Polarisierungsstroms; und
- Mittel (27) zum Kompensieren des Gleichtaktstroms an den Ausgängen (C, D) des translinearen Vervielfachers, die eine Steuerung dieses Gleichtaktstromes an dem von den Polarisierungsmitteln gelieferten Strom bewirken.

2. Verstärkerelement nach Anspruch 1, dadurch gekennzeichnet, dass der translineare Vervielfacher (25) umfasst: ein Paar von Eingangstransistoren (T5, T8) und wenigstens ein Paar von differentiellen Ausgangstransistoren (T6, T7), wobei die Ausgangstransistoren (T6, T7) des differentiellen Paars eine erste gemeinsame Klemme aufweisen, die (T6, T7) des translinearen Vervielfachers (25) durchfließenden verstärkten Ströme bildet, dass die Polarisierungsmittel umfassen wenigstens einen Stromspiegel, bestehend aus einem ersten Zweig, der einen Ursprungsstrom führt, und wenigstens einem zweiten Zweig, der einen kopierten Strom führt, wobei der erste Stromspiegelzweig einen ersten Zweigtransistor, der über eine erste Klemme mit den Eingangstransistoren des translinearen Vervielfachers verbunden ist, und der zweite Stromspiegelzweig einen zweiten Zweigtransistor umfasst, der über eine erste Klemme mit dem Stromadditionspunkt des translinearen Vervielfachers und über eine zweite Klemme mit einer zweiten Klemme des ersten Zweigtransistors verbunden ist,
und dass die Gleichtaktstromkompensationsmittel umfassen:
- Kopiermittel zum Kopieren des von dem zweiten Stromspiegel-Zweigtransistor geführten Gleichtaktstromes und
- Mittel (32; 42) zum Einspeisen eines von den Stromkopiermitteln (31; 41) kopierten Stromes in eine zweite Klemme eines jeden der Ausgangstransistoren (T6, T7) des translinearen Vervielfachers (25), wobei die zweiten Klemmen der Ausgangstransistoren die Ausgänge (C, D) des translinearen Vervielfachers bilden.

3. Verstärkerelement nach Anspruch 2, dadurch gekennzeichnet, dass die Gleichtaktstrom-Kopiermittel (31; 41) einen zweiten zusätzlichen Stromspiegelzweig (31; 43) umfassen, der einen Transistor (T9) eines zweiten Zweiges umfasst, der über eine erste Klemme mit den Mitteln (32; 42) zum Einspeisen und über eine zweite Klemme mit der zweiten Klemme des Transistors (T1) des ersten Zweiges der Polarisierungsmittel (26) verbunden ist.

4. Verstärkerelement nach Anspruch 3, dadurch gekennzeichnet, dass die Gleichtaktstrom-Kopiermittel (41) Mittel (44) zum Aufrechterhalten einer konstanten Spannung umfassen, die es erlauben, an der ersten Klemme des Transistors (T9) des zweiten zusätzlichen Stromspiegelzweiges eine Spannung zu erzielen, die gleich derjenigen ist, die an der ersten Klemme des Transistors (T1) des ersten Zweigs der Polarisierungsmittel (26) besteht.

5. Verstärkerelement nach Anspruch 4, dadurch gekennzeichnet, dass die Mittel (44) zum Aufrechterhalten einer konstanten Spannung umfassen:
einen ersten Transistor (T13) zum Spannung Aufrechterhalten, der über eine erste Klemme an die Mittel (42) zum Einspeisen eines kopierten Stromes, über eine zweite Klemme an einen der Eingänge (A) des translinearen Vervielfachers (25) und über eine dritte Klemme an die erste Klemme des Transistors (T9) des zweiten zusätzlichen Stromspiegelzweiges angeschlossen ist, und
einen zweiten Transistor (T14), zum Spannung Aufrechterhalten, der über eine erste Klemme an die Mittel (42) zum Einspeisen eines kopierten Stromes, über eine zweite Klemme an den anderen der Eingänge (B) des translinearen Vervielfachers (25) und über eine dritte Klemme an die erste Klemme des Transistors (T9) des zweiten zusätzlichen Stromspiegelzweiges angeschlossen ist.

6. Verstärkerelement nach einem der Ansprüche 2 bis 5, dadurch gekennzeichnet, dass die Mittel (41, 42) zum Einspeisen eines kopierten Stromes wenigstens zwei erste Stromspiegel ((T10, T11), (T10, T12)) umfassen, die jeweils einen an die Gleichtaktstrom-Kopiermittel (31; 41) angeschlossenen ersten Zweig und einen an einen der Ausgänge (C, D) des translinearen Vervielfachers (25) angeschlossenen zweiten Zweig haben, wobei die ersten Zweige der zwei ersten Stromspiegel gemeinsam sind.

7. Verstärkerelement nach Anspruch 6, dadurch gekennzeichnet, dass die Mittel (41) zum Einspeisen eines kopierten Stromes zwei zweite Stromspiegel ((T15, T16), (T15, T17)) umfassen, die mit den ersten Stromspiegeln hintereinandergeschaltet sind.

8. Verstärkerelement nach einem der Ansprüche 1 bis 7, dadurch gekennzeichnet, dass es Mittel (21, 22) zum Erzeugen eines Gleichtakt-Polarisierungsstromes umfasst, die zu der die Stromquellen und die Widerstände umfassenden Gruppe gehören.

9. Verstärkerelement nach einem der Ansprüche 1 bis 8, dadurch gekennzeichnet, dass es eine Eingangszelle (6) umfasst, die vor dem translinearen Vervielfacher (25) angeordnet ist und eine sehr geringe Eingangsimpedanz hat.

10. Verstärkerelement nach Anspruch 9, dadurch gekennzeichnet, dass die Eingangszelle einen doppelten Stromförderer umfasst.

11. Verstärkerelement nach einem der Ansprüche 1 bis 10, dadurch gekennzeichnet, dass es Transistoren umfasst, die zu der Gruppe gehören, die die Bipolartransistoren und die MOS-Transistoren umfasst.

12. Verstärkerelement nach Anspruch 11 und einem beliebigen der Ansprüche 2 bis 10, dadurch gekennzeichnet, dass die in dem translinearen Vervielfacher (25), den Polarisierungsmitteln (26) und den Gleichtaktstrom-Kopiermitteln (31; 41) enthaltenen Transistoren vom NPN-Typ sind,
und dass die in den Mitteln (32; 42) zum Einspeisen eines kopierten Stromes enthaltenen Transistoren vom PNP-Typ sind.

13. Verstärkerelement nach Anspruch 11 und einem beliebigen der Ansprüche 2 bis 10, dadurch gekennzeichnet, dass die in dem translinearen Vervielfacher (25), den Polarisierungsmitteln (26) und den Gleichtaktstrom-Kopiermitteln (31; 41) enthaltenen Transistoren vom PNP-Typ sind,
und dass die in den Mitteln (32; 42) zum Einspeisen eines kopierten Stromes enthaltenen Transistoren vom NPN-Typ sind.

14. Verstärkerelement nach Anspruch 11 und einem beliebigen der Ansprüche 2 bis 10, dadurch gekennzeichnet, dass die in dem translinearen Vervielfacher (25), den Polarisierungsmitteln (26) und den Gleichtaktstrom-Kopiermitteln (31; 41) enthaltenen Transistoren vom NMOS-Typ sind,
und dass die in den Mitteln (32; 42) zum Einspeisen eines kopierten Stromes enthaltenen Transistoren vom PMOS-Typ sind.

15. Verstärkerelement nach Anspruch 11 und einem beliebigen der Ansprüche 2 bis 10, dadurch gekennzeichnet, dass die in dem translinearen Vervielfacher (25), den Polarisierungsmitteln (26) und den Gleichtaktstrom-Kopiermitteln (31; 41) enthaltenen Transistoren vom PMOS-Typ sind,
und dass die in den Mitteln (32; 42) zum Einspeisen eines kopierten Stromes enthaltenen Transistoren vom NMOS-Typ sind.

## Claims

1. Differential current mode amplifier device comprising:
- means (21, 22) for generating a common mode bias current (23, 24);
- a translinear multiplier (25) receiving at two inputs (A, B) said common mode bias current (23, 24) and a differential mode current (28, 29) to be amplified and delivering at two outputs (C, D) an amplified differential mode current;
- means (26) for biasing said translinear multiplier (25) in a manner dependent on said bias current received by said translinear multiplier; and
- means (27) for compensating the common mode current at said outputs (C, D) of said translinear multiplier, slaving this common mode current to the current supplied by said biasing means.

2. Amplifier device according to claim 1 characterised in that said translinear multiplier (25) includes a pair of input transistors (T5, T8) and at least one differential pair of output transistors (T6, T7), said output transistors (T6, T7) of said differential pair having a common first terminal constituting a point of addition (F) of amplified currents through said output transistors (T6, T7) of said translinear multiplier (25),
said bias means include at least one current mirror having a first branch conveying an original current and at least one second branch conveying a copy current, said first current mirror branch including a first branch transistor connected by a first terminal to said input transistors of said translinear multiplier, said second current mirror branch including a second branch transistor connected by a first terminal to said current addition point of said translinear multiplier and by a second terminal to a second terminal of said first branch transistor, and
said common mode current compensator means comprise:
- means for copying the common mode current conveyed by said second current mirror branch transistor, and
- means for injecting (32; 42) a common mode current copied by said current copier means (31; 41) into a second terminal of each of said output transistors (T6, T7) of said translinear multiplier (25), said second terminals of said output transistors constituting said outputs (C, D) of said translinear multiplier.

3. Amplifier device according to claim 2 characterised in that said common mode current copier means (31; 41) include an additional second current mirror branch (31; 43) including a second branch transistor (T9) connected by a first terminal to said injector means (32; 42) and by a second terminal to said second terminal of said first branch transistor (T1) of said bias means (26).

4. Amplifier device according to claim 3 characterised in that said common mode current copier means (41) include means (44) for maintaining a constant voltage in order to obtain at said first terminal of said transistor (T9) of said additional second current mirror branch a voltage equal to that at said first terminal of said first branch transistor (T1) of said bias means (26).

5. Amplifier device according to claim 4 characterised in that said means (44) for maintaining a constant voltage include:
- a first voltage maintaining transistor (T13) connected by a first terminal to said copied current injector means (42), by a second terminal to one of said inputs (A) of said translinear multiplier (25) and by a third terminal to said first terminal of said additional second current mirror branch transistor (T9), and
- a second voltage maintaining transistor (T14) connected by a first terminal to said copied current injector means (42), by a second terminal to the other of said inputs (B) of said translinear multiplier (25) and by a third terminal to said first terminal of said additional second current mirror branch transistor (T9).

6. Amplifier device according to any one of claims 2 to 5 characterised in that said copied current injector means (41; 42) include at least two first current mirrors ((T10, T11), (T10, T12)) each having a first branch connected to said common mode current copier means (31; 41) and a second branch connected to one of said outputs (C, D) of said translinear multiplier (25), said first branches of said two first current mirrors being common.

7. Amplifier device according to claim 6 characterised in that said copied current injector means (41) include two second current mirrors ((T15, T16), (T15, T17)) in cascade with said first current mirrors.

8. Amplifier device according to any one of claims 1 to 7 characterised in that said common mode bias current generator means (21, 22) are selected from the group comprising current sources and resistors.

9. Amplifier device according to any one of claims 1 to 8 including an input cell (6) on the input side of said translinear multiplier (25) having a very low input impedance.

10. Amplifier device according to claim 9 characterised in that said input cell (6) includes a double current conveyor.

11. Amplifier device according to any one of claims 1 to 10 including transistors selected from the group comprising bipolar transistors and MOS transistors.

12. Amplifier device according to claim 11 and any one of claims 2 to 10 characterised in that the transistors in said translinear multiplier (25), said bias means (26) and said common mode current copier means (31; 41) are NPN transistors and the transistors in said copied current injector means (32; 42) are PNP transistors.

13. Amplifier device according to claim 11 and any one of claims 2 to 10 characterised in that the transistors in said translinear multiplier (25), said bias means (26) and said common mode current copier means (31; 41) are PNP transistors and the transistors in said copied current injector means (32; 42) are NPN transistors.

14. Amplifier device according to claim 11 and any one of claims 2 to 10 characterised in that the transistors in said translinear multiplier (25), said bias means (26) and said common mode current copier means (31; 41) are NMOS transistors and the transistors in said copied current injector means (32; 42) are PMOS transistors.

15. Amplifier device according to claim 11 and any one of claims 2 to 10 characterised in that the transistors in said translinear multiplier (25), said bias means (26) and said common mode current copier means (31; 41) are PMOS transistors and the transistors in said copied current injector means (32; 42) are NMOS transistors.
